# EUROPEAN PATENT APPLICATION

(11) **EP 2 762 796 A1**
(43) Date of publication of application: **06.08.2014**
(21) Application number: 13153787.0
(22) Date of filing: 04.02.2013
(51) Int. Cl.: F24F 13/10, H05K 7/20, H01H 9/52, F28D 21/00

(54) **Cooling assembly**

(71) Applicant: ABB Oy, 00380 Helsinki (FI)
(72) Inventor: Manninen, Jorma, 00380 Helsinki (FI); Koivuluoma, Timo, 00380 Helsinki (FI); Lehto, Jaakko, 00380 Helsinki (FI)
(74) Representative: Kolster Oy Ab

(57) **Abstract**

A cooling assembly comprising a device chamber (2), a cooling chamber (4) separated from the device chamber (2), a heat exchanger (3), device chamber fan means and control means (6), the heat exchanger (3) comprising a first portion (31) located in the device chamber (2) and a second portion (32) located in the cooling chamber (4) for transferring heat from the device chamber (2) to the cooling chamber (4), the device chamber fan means being adapted to generate a device chamber cooling medium flow comprising a first partial flow interacting with the first portion (31) of the heat exchanger (3). The cooling assembly further comprises first throttle means (81) for regulating the first partial flow, the control means (6) being adapted to reduce a cooling power of the heat exchanger (3) as a response to predetermined operating conditions by decreasing the first partial flow with the first throttle means (81).

## Description

### FIELD OF THE INVENTION

The present invention relates to a cooling assembly comprising a heat exchanger for transferring heat from a device chamber.

### BACKGROUND OF THE INVENTION

Humidity is harmful to many electronic components. Humidity is an issue for example in solar power plants and wind power plants. Challenging environment such as tropical climate or arctic climate increases problems caused by humidity.

In a known cooling assembly heating of a device chamber is used to prevent excessive humidity. It is also known to use water absorbing materials such as silica gel to remove humidity from a device chamber.

Preventing humidity by means of heating induces extra cost. Water absorbing materials are also expensive and their useful life is limited thereby further increasing cost.

### BRIEF DESCRIPTION OF THE INVENTION

An object of the present invention is to provide a cooling assembly capable of alleviating disadvantages caused by humidity. The object of the invention is achieved by a cooling assembly which is characterized by what is stated in the independent claim. The preferred embodiments of the invention are disclosed in the dependent claims.

The invention is based on the idea of decreasing in predetermined operating conditions a relative humidity level in a device chamber by reducing a cooling power of a heat exchanger adapted to transfer heat from the device chamber, the cooling power being reduced by first throttle means capable of regulating a first partial flow of cooling medium interacting with a first portion of the heat exchanger located in the device chamber. The invention improves controllability of a heat exchanger by lowering a minimum cooling power of the heat exchanger. Decreasing cooling power of a heat exchanger raises temperature in a device chamber thereby reducing relative humidity.

An advantage of the cooling assembly of the invention is that a relative humidity level inside a device chamber can be decreased with very small operating cost.

### BRIEF DESCRIPTION OF THE DRAWINGS

In the following the invention will be described in greater detail by means of preferred embodiments with reference to the attached drawings, in which
Figure 1 shows a cooling assembly according to a first embodiment of the invention;
Figure 2 shows a cooling assembly according to a second embodiment of the invention; and
Figure 3 shows a cooling assembly according to a third embodiment of the invention.

### DETAILED DESCRIPTION OF THE INVENTION

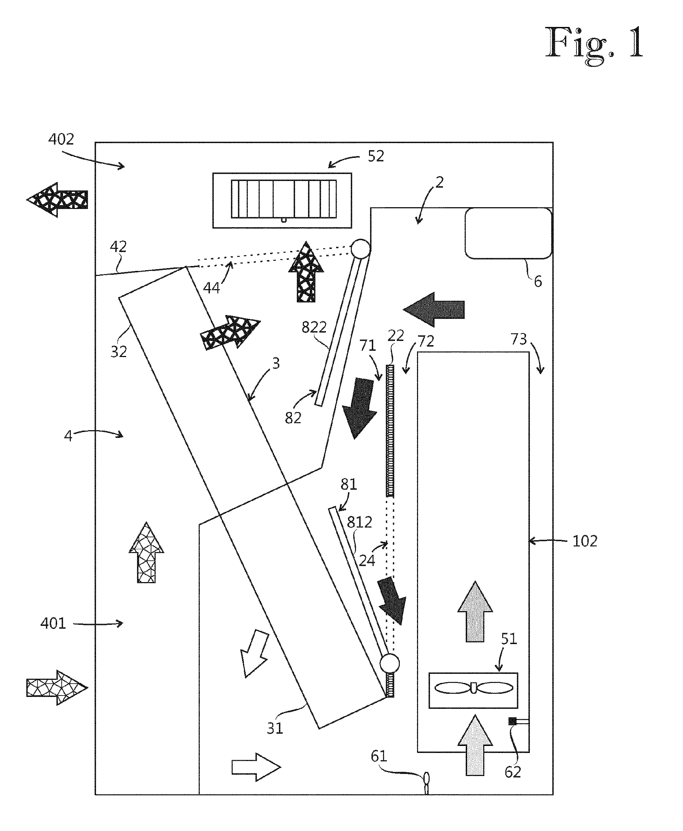

Figure 1 shows a cooling assembly comprising a device chamber 2, a cooling chamber 4, a heat exchanger 3, device chamber fan means, control means 6, a humidity sensor 61, a temperature sensor 62, first throttle means 81, and an electrical apparatus 102. The cooling chamber 4 is separated from the device chamber 2. The heat exchanger 3 comprises a first portion 31 located in the device chamber 2 and a second portion 32 located in the cooling chamber 4 for transferring heat from the device chamber 2 to the cooling chamber 4. The first portion 31 of the heat exchanger is in an operating situation located lower than the second portion 32 of the heat exchanger.

The device chamber fan means are adapted to generate a device chamber cooling medium flow comprising a first partial flow interacting with the first portion 31 of the heat exchanger 3. Herein interaction between a cooling medium flow and a heat exchanger means heat transfer between the cooling medium flow and the heat exchanger. The first throttle means 81 are adapted for regulating the first partial flow. The humidity sensor 61 is adapted to detect humidity level in the device chamber 2. The temperature sensor 62 is adapted to detect a temperature in the device chamber 2.

The control means 6 are adapted to reduce a cooling power of the heat exchanger 3 as a response to predetermined operating conditions by decreasing the first partial flow with the first throttle means 81. The first throttle means 81 are adapted to regulate the first partial flow by adjusting a bypass flow of the cooling medium, the bypass flow being a portion of the device chamber cooling medium flow that bypasses the first portion 31 of the heat exchanger 3 without interaction. The predetermined operating conditions comprising a situation where the humidity sensor 61 detects a humidity level exceeding a predetermined threshold value in the device chamber 2, and a situation where the temperature sensor 62 detects a temperature below a predetermined threshold value in the device chamber 2. In an embodiment a predetermined condition is defined as a function of humidity and temperature.

A wall 22 separates a first flow channel 71 from a second flow channel 72. The first portion 31 of the heat exchanger 3 is located in the first flow channel 71. The second flow channel 72 extends between the electrical apparatus 102 and the wall 22 bypassing the first portion 31 of the heat exchanger 3. There is an opening 24 in the wall 22 providing a passage between the first flow channel 71 and the second flow channel 72. The first throttle means 81 comprise a generally planar first valve plate 812 adapted to pivot about a pivoting axis extending substantially parallel to a plane defined by the first valve plate 812. The pivoting axis passes through a lower edge of the first valve plate 812. The first valve plate 812 has a closed position and an open position. In the closed position the first valve plate 812 closes the opening 24 in the wall 22. In Figure 1 the closed position of the first valve plate 812 is depicted with a dash line. In the open position the first valve plate 812 allows a bypass flow of the cooling medium from the first flow channel 71 to the second flow channel 72 through the opening 24. In Figure 1 the first valve plate 812 is in the open position.

The first valve plate 812 only has two positions, the open position and the closed position. In alternative embodiments first throttle means may have more than two positions including at least one intermediate position between an open position and a closed position. Alternatively control means may be adapted to alternate position of the first throttle means between an open position and a closed position in order to provide an average bypass flow of the cooling medium smaller than the bypass flow corresponding to the open position of the first throttle means.

The heat exchanger 3 is a cothex type heat exchanger. A cothex is a thermosyphon heat exchanger where cooling medium circulates by means of natural convection without a mechanical pump. In an alternative embodiment a heat exchanger adapted to transfer heat from the device chamber to the cooling chamber may comprise another type of passive heat exchanger, or an active heat exchanger.

The electrical apparatus 102 is provided with apparatus cooling fan means 51 located inside a housing of the electrical apparatus 102 and adapted for cooling the electrical apparatus 102. In the embodiment of Figure 1 the device chamber fan means consists of the apparatus cooling fan means 51.

One skilled in the art understands that relative humidity in the device chamber 2 could be slightly decreased by reducing power of apparatus cooling fan means 51. However, reducing a power of apparatus cooling fan means 51 could lead to unfavourable heat distribution inside the electrical apparatus 102. Further, reducing a power of apparatus cooling fan means 51 could in fact increase relative humidity in some parts of the device chamber 2.

In an alternative embodiment the device chamber fan means comprise at least one fan not belonging to the apparatus cooling fan means but specifically adapted to generate a device chamber cooling medium flow. Such at least one fan may be located separately from the electrical apparatus.

The electrical apparatus 102 comprises a frequency converter. In an alternative embodiment an electrical apparatus located in the device chamber may comprise an inverter or some other heat generating apparatus that requires cooling.

In the embodiment of Figure 1 the device chamber cooling medium flow always comprises some bypass flow of the cooling medium irrespective of operation of the first throttle means 81. In the closed position of the first valve plate 812 a bypass flow passes through the second flow channel 72 and a third flow channel 73 extending between the electrical apparatus 102 and an inner wall of the device chamber 2.

In an alternative embodiment a closed position of first throttle means substantially prevents a bypass flow of the cooling medium, the bypass flow being a portion of the device chamber cooling medium flow that bypasses the first portion of the heat exchanger without interaction. For example, by blocking the second flow channel 72 and the third flow channel 73 in the cooling assembly of Figure 1 would provide such an embodiment.

The cooling assembly further comprises second throttle means 82 and cooling chamber fan means 52 for regulating a cooling chamber cooling medium flow interacting with the second portion 32 of the heat exchanger 3. The control means 6 are adapted to reduce a cooling power of the heat exchanger 3 as a response to predetermined operating conditions by decreasing the cooling chamber cooling medium flow by controlling the second throttle means 82 and the cooling chamber fan means 52.

The device chamber 2 is separated from the cooling chamber 4 such that there is substantially no cooling medium flow between the device chamber 2 and the cooling chamber 4. Therefore substantially no contaminant particles can pass from the cooling chamber 4 into the device chamber 2. The cooling medium in the cooling chamber 4 as well as in the device chamber 2 is air.

A wall 42 separates a first portion 401 of the cooling chamber 4 from a second portion 402 of the cooling chamber 4. The first portion 401 of the cooling chamber 4 comprises the second portion 32 of the heat exchanger 3. The second portion 402 of the cooling chamber 4 comprises the cooling chamber fan means 52. The second portion 402 is in an operating situation located above the first portion 401. There is an opening 44 in the wall 42 providing a passage between the first portion 401 of the cooling chamber 4 and the second portion 402 of the cooling chamber 4.

The second throttle means 82 comprise a generally planar second valve plate 822 adapted to pivot about a pivoting axis extending substantially parallel to a plane defined by the second valve plate 822. The pivoting axis passes through an upper edge of the second valve plate 822. The second valve plate 822 has a closed position and an open position. In the closed position the second valve plate 822 closes the opening 44 in the wall 42. In Figure 1 the closed position of the second valve plate 822 is depicted with a dash line. In the open position depicted in Figure 1 the second valve plate 822 allows a flow of cooling medium from the first portion 401 of the cooling chamber 4 to the second portion 402 of the cooling chamber 4 through the opening 44. The open position of the second valve plate 822 increase a cooling power of the heat exchanger 3 compared to the closed position of the second valve plate 822 because a lower part of the first portion 401 of the cooling chamber 4 and the second portion 402 of the cooling chamber 4 comprise openings allowing cooling medium to flow between exterior of the cooling assembly and the cooling chamber 4. Consequently the open position of the second valve plate 822 induces a draught in the cooling chamber 4 during operation of the cooling assembly.

When the control means 6 detect an operating condition that requires or allows reducing cooling power of the heat exchanger 3, the control means 6 turns off the cooling chamber fan means 52. If the turning off of the cooling chamber fan means 52 does not reduce a cooling power of the heat exchanger 3 enough the control means 6 opens the first valve plate 812 and/or closes the second valve plate 822.

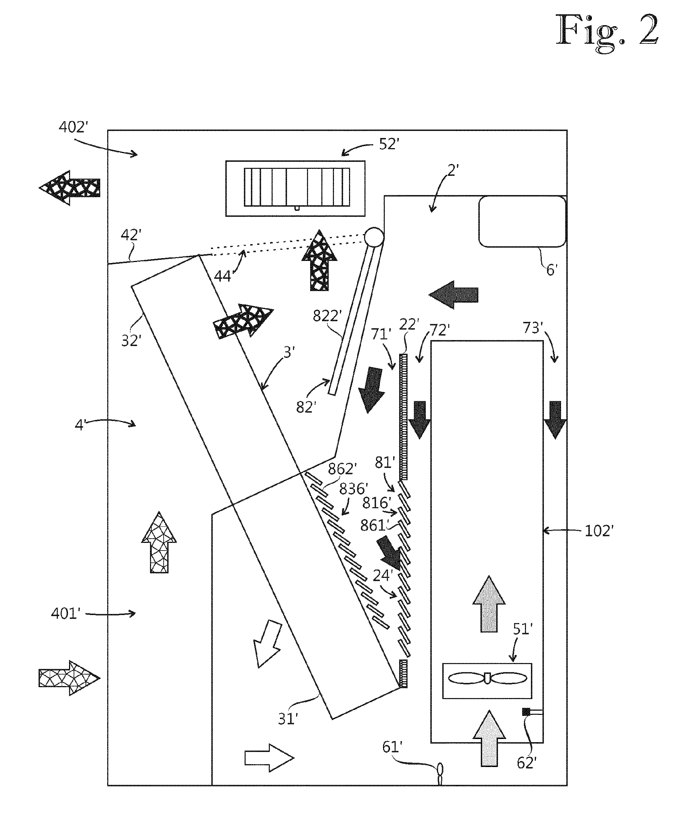

In the embodiment of Figure 1 the first throttle means 81 comprise only one valve member, namely the first valve plate 812. In an alternative embodiment first throttle means may comprise a plurality of valve members. For example Figure 2 shows a cooling assembly in which first throttle means 81' comprise a first adjustable grill 816' and a second adjustable grill 836'. The first adjustable grill 816' comprises a plurality of louvers 861', and the second adjustable grill 836' comprises a plurality of louvers 862'.

The first adjustable grill 816' is located in an opening 24' in a wall 22', and is adapted to regulate a cooling medium flow through the opening 24'. The second adjustable grill 836' is located adjacent an upper surface of the first portion 31' of the heat exchanger 3'. Control means 6' are adapted to control both the first adjustable grill 816' and the second adjustable grill 836'. A first partial flow interacting with the first portion 31' of the heat exchanger 3' is minimized by an open position of the first adjustable grill 816' and a closed position of the second adjustable grill 836'. The first partial flow is maximized by a closed position of the first adjustable grill 816' and an open position of the second adjustable grill 836'.

Control means 6' are capable of steplessly control the first adjustable grill 816' and the second adjustable grill 836'. In Figure 2 both the first adjustable grill 816' and the second adjustable grill 836' are in an intermediate position between an open and closed position.

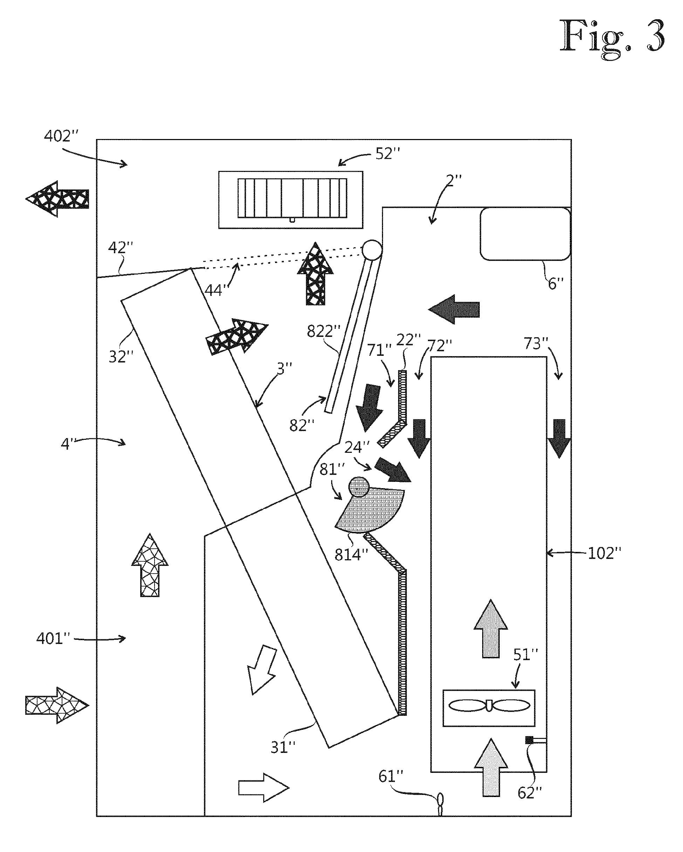

Valve member type of first throttle means and second throttle means is not limited to a planar valve plate and an adjustable grill. Figure 3 shows a cooling assembly in which first throttle means 81" comprise a cylindrical valve 814" whose valve surface has a general form of a cylindrical segment. The valve surface of the cylindrical valve 814" is adapted to pivot about a pivoting axis extending substantially parallel to an axis of the cylindrical segment. Control means 6" are capable of steplessly control the cylindrical valve 814".

It should be noticed that although both second throttle means 82' of Figure 2 and second throttle means 82" of Figure 3 comprise a generally planar second valve plate, the second throttle means may alternatively comprise an adjustable grill, a cylindrical valve, or any other suitable valve member.

Except for the first throttle means the cooling assemblies of Figures 1 to 3 are quite similar. The only further significant difference relates to a wall separating a first flow channel from a second flow channel. For example, in the cooling assembly of Figure 3 the segments of wall 22" located adjacent the cylindrical valve 814" are inclined towards the cylindrical valve 814" in order to better co-operate with it. The wall segments have been inclined because of a relatively long radius of the cylindrical valve 814" and a relatively short distance between a wall 22" and an electrical apparatus 102".

In an embodiment a cooling assembly comprises heating means for heating the device chamber. In said embodiment control means are adapted to decrease the first partial flow with the first throttle means when the heating means are in use. Such operation improves efficiency of the heating by reducing heat loss from the device chamber.

It will be obvious to a person skilled in the art that the inventive concept can be implemented in various ways. The invention and its embodiments are not limited to the examples described above but may vary within the scope of the claims.

## Claims

1. A cooling assembly comprising a device chamber (2), a cooling chamber (4) separated from the device chamber (2), a heat exchanger (3), device chamber fan means and control means (6), the heat exchanger (3) comprising a first portion (31) located in the device chamber (2) and a second portion (32) located in the cooling chamber (4) for transferring heat from the device chamber (2) to the cooling chamber (4), the device chamber fan means being adapted to generate a device chamber cooling medium flow comprising a first partial flow interacting with the first portion (31) of the heat exchanger (3), **characterized in that** the cooling assembly further comprises first throttle means (81) for regulating the first partial flow, the control means (6) being adapted to reduce a cooling power of the heat exchanger (3) as a response to predetermined operating conditions by decreasing the first partial flow with the first throttle means (81).

2. A cooling assembly according to claim 1, **characterized in that** the cooling assembly comprises a humidity sensor (61) adapted to detect humidity level in the device chamber (2), said predetermined operating conditions comprising a situation where the humidity sensor (61) detects a humidity level exceeding a predetermined threshold value in the device chamber (2).

3. A cooling assembly according to claim 1 or 2, **characterized in that** the cooling assembly comprises a temperature sensor (62) adapted to detect a temperature in the device chamber (2), said predetermined operating conditions comprising a situation where the temperature sensor (62) detects a temperature below a predetermined threshold value in the device chamber (2).

4. A cooling assembly according to any preceding claim, **characterized in that** the first throttle means (81) are adapted to regulate the first partial flow by adjusting a bypass flow of the cooling medium, the bypass flow being a portion of the device chamber cooling medium flow that bypasses the first portion (31) of the heat exchanger (3) without interaction.

5. A cooling assembly according to any preceding claim, **characterized in that** the first throttle means (81) comprise a generally planar first valve plate (812) adapted to pivot about a pivoting axis extending substantially parallel to a plane defined by the first valve plate (812).

6. A cooling assembly according to any preceding claim, **characterized in that** the first throttle means (81 ") comprise a cylindrical valve (814") whose valve surface has a general form of a cylindrical segment, the valve surface being adapted to pivot about a pivoting axis extending substantially parallel to an axis of the cylindrical segment.

7. A cooling assembly according to any preceding claim, **characterized in that** the first throttle means (81') comprise a first adjustable grill (816') with a plurality of louvers (861').

8. A cooling assembly according to any preceding claim, **characterized in that** the first portion (31) of the heat exchanger (3) is in operating situation located lower than the second portion (32) of the heat exchanger (3).

9. A cooling assembly according to claim 8, **characterized in that** the heat exchanger (3) comprises a passive heat exchanger.

10. A cooling assembly according to claim 9, **characterized in that** the heat exchanger (3) comprises a thermosyphon heat exchanger.

11. A cooling assembly according to any preceding claim, **characterized in that** the cooling assembly further comprises second throttle means (82) for regulating a cooling chamber cooling medium flow interacting with the second portion (32) of the heat exchanger (3), the control means (6) being adapted to reduce a cooling power of the heat exchanger (3) as a response to predetermined operating conditions by decreasing the cooling chamber cooling medium flow with the second throttle means (82).

12. A cooling assembly according to any preceding claim, **characterized in that** there is an electrical apparatus (102) in the device chamber (2), the electrical apparatus (102) being provided with apparatus cooling fan means (51) adapted for cooling the electrical apparatus (102), the apparatus cooling fan means (51) constituting at least part of the device chamber fan means.

13. A cooling assembly according to claim 12, **characterized in that** the device chamber fan means consists of the apparatus cooling fan means (51).

14. A cooling assembly according to claim 12 or 13, **characterized in that** the electrical apparatus (102) comprises a frequency converter or inverter.
